# EUROPEAN PATENT APPLICATION

(11) **EP 2 012 154 A1**
(43) Date of publication of application: **07.01.2009**
(21) Application number: 07740217.0
(22) Date of filing: 29.03.2007
(51) Int. Cl.: G02B 6/42, G02B 6/122, H01S 5/022

(54) **OPTICAL DEVICE AND OPTICAL DEVICE MANUFACTURING METHOD**

(30) Priority: 26.04.2006 JP 2006122102
(71) Applicant: Mitsumi Electric Co., Ltd., Tama-shi, Tokyo 206-8567 (JP)
(72) Inventor: NAKANE, Taketomo, Tama-shi, Tokyo 206-8567 (JP)
(74) Representative: Grünecker, Kinkeldey, Stockmair & Schwanhäusser Anwaltssozietät
(86) International application number: PCT/JP2007/056779
(87) International publication number: WO 2007/125716

(57) **Abstract**

Scattering loss at a reflecting or transmitting end face of an optical unit is reduced, and the end face is easily manufactured at low cost. An optical waveguide cable (2) as an optical device is provided, as an optical unit, with a core layer (231, 232) serving as an optical waveguide and cladding layers (21, 22) with which the core layer (231, 232) is covered. The core layer (231, 232) and the cladding layers (21, 22) are provided with a diced facet (241) as a processed surface for reflecting light, and a smoothing film (242) is provided on the diced facet (24).

## Description

### TECHNICAL FIELD

The present invention relates to an optical device and an optical device manufacturing method.

### BACKGROUND ART

Conventionally, in the field of optical communication, optical devices having an optical path converter for deflecting (or converting) an optical path of laser light have been devised. For example, a configuration in which a mirror surface is provided in an optical waveguide such as an optical fiber, planar lightwave circuit (PLC) or light guide cable to deflect an optical path by 90 degrees has been devised.

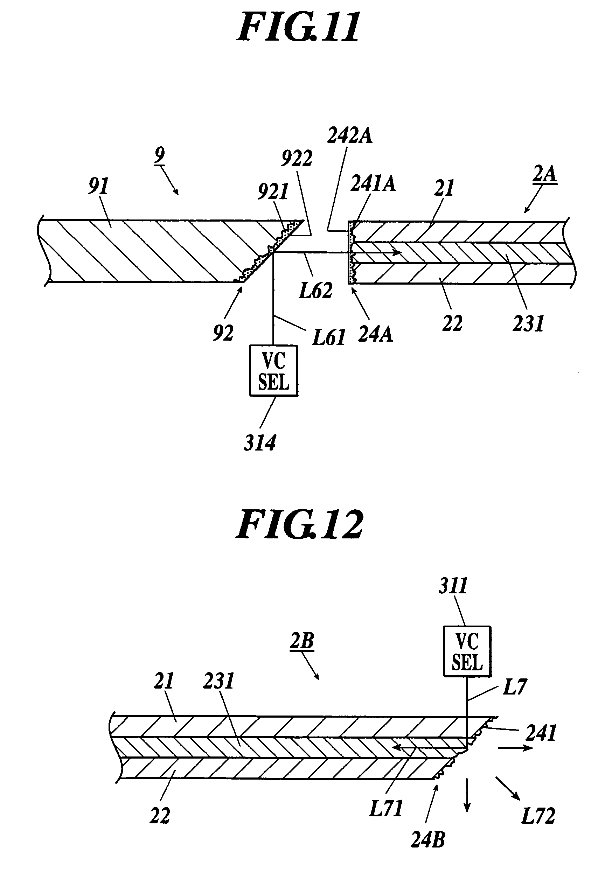

Fig. 12 is a cross sectional view showing the configuration of an optical waveguide cable 2B of a conventional optical cable. As shown in Fig. 12, in the optical cable with which optical communication is performed utilizing conversion between electrical signals and light signals, the optical waveguide cable 2B serving as a transmission path for light signals is composed of cladding layers 21, 22 and a core layer 231, and a mirror surface 24B oriented at an angle of 45 degrees relative to the optical path is provided at an end face thereof.

The mirror surface 24B has a diced facet 241 formed by dicing the cladding layers 21, 22 and the core layer 231 using a blade having an angle of 45 degrees. Laser light emitted from a VCSEL (Vertical Cavity Surface Emitting LASER) 311 is reflected by the diced facet 241 and transmitted in the core layer 231. In other words, optical path conversion is achieved by reflection using a difference in the optical index between the air and the core layer 231 at the diced facet 241. In an optical waveguide cable that serves as a light signal receiving path also, laser light propagated in the core layer is reflected by a diced facet and made incident on a PD (Photo Diode) that is not shown in the drawing.

Furthermore, there has been devised a structure in which a dielectric multilayer film is provided on an inclined surface serving as the above-mentioned mirror surface so that only light of a predetermined wavelength is reflected (see, for example, patent document 1).

Still further, there has been devised a structure in which gold, silver or aluminum is vapor-deposited on the above-mentioned inclined surface (see, for example, patent documents 2 and 3).

Yet still further, there has been devised a structure in which a V-shaped groove cut on the above-mentioned inclined surface is filled with an ultraviolet curing resin (see, for example, patent document 3).
Patent Document 1: Japanese Patent Application Laid-Open No. 1-312514
Patent Document 2: Japanese Patent Application Laid-Open No. 63-191111
Patent Document 3: Japanese Patent Application Laid-Open No. 10-300961

### DISCLOSURE OF THE INVENTION

### The Problems to be solved by the Invention

However, in the conventional mirror surface configuration as shown in Fig. 12, scattering occurs due to unevenness of the diced facet 241. For example, scattering occurs even in a case where the surface roughness Ra of the diced facet 241 is 10 nm. Specifically, upon reflection of the laser light L8 at the diced facet 241, reflected light L71 is emitted into the core layer 23, and in addition scattered light L72 is emitted to the air. Thus, there has been a problem of a decrease in the reflection factor, or an increase in the transmission loss (scattering loss).

In the method disclosed in patent document 1 in which a dielectric multilayer film is formed on the inclined surface, the film is formed for a different purpose, and the method does not eliminate scattering loss yet. The method disclosed in patent documents 2 and 3 in which gold, silver or aluminum is vapor-deposited on the inclined surface does not eliminate scattering loss yet.

The method disclosed in patent document 3 in which a V-shaped groove on the inclined surface is filled with an ultraviolet curing resin does not eliminate scattering loss yet. In addition, the need of the V-shaped groove places a limit on the applications and leads to an increase in the cost, and it does not eliminate scattering loss yet.

In order to prevent the above-mentioned scattering loss, it is desired that the mirror surface be smoothed. One conceivable solution is, for example, to process the mirror surface using laser light. However, it has not been possible for the method using laser light to achieve high accuracy in the inclination angle of the mirror surface.

Another conceivable solution is to polish the diced facet after it is formed. However, the method using polishing makes the process complex. For example, it is required to attach a waveguide once on a substrate in order to perform polishing. Such an increase in the complexity of the operation has caused an increase in the cost.

Still another conceivable solution is to perform dicing using a finer dicing blade to decrease the surface unevenness. However, in cases where the material of the optical waveguide is a polymer, there is a possibility that use of a finer dicing blade leads to clogging of the blade. A reduction in the scattering loss is also demanded not only in a mirror surface of an optical waveguide but also in a processed surface in a light transmissive surface (incident surface or exit surface) of an optical waveguide and an optical unit other than optical waveguides.

An object of the present invention is to reduce the scattering loss at an end face of an optical unit for reflection or transmission and to form such an end face easily at a low cost.

### Means for Solving the Problems

To achieve the above object, an optical device according to the invention as recited in claim 1 comprises: an optical unit, wherein the optical unit includes a processed surface for reflecting or transmitting light, and a smoothing film is provided on the processed surface.

The invention as recited in claim 2 is characterized in that in the invention according to claim 1, the optical unit includes a core serving as an optical waveguide and cladding with which the core is covered.

The invention as recited in claim 3 is characterized in that in the optical device according to claim 2, the smoothing film has a refractive index equal to or nearly equal to the refractive index of the core.

The invention as recited in claim 4 is characterized in that in the optical device according to claim 2 or 3, the core has a plurality of layers.

The invention as recited in claim 5 is characterized in that in the optical waveguide device according to any one of claims 1 to 4, at least one of a light emitting unit for emitting light to the smoothing film, a light receiving unit for receiving light reflected by the smoothing film and a light transmitting unit for emitting light to or receiving light from the smoothing film.

An optical device manufacturing method according to the invention as recited in claim 6 is characterized by comprising:
an optical unit forming step of forming an optical unit;
a processed surface forming step of forming a processed surface for reflecting or transmitting light;
a smoothing film forming step of forming a smoothing film on the processed surface to produce an optical device.

The invention as recited in claim 7 is characterized in that in the optical device manufacturing method according to claim 6, the optical unit forming step comprises a step of forming a core serving as an optical waveguide and cladding with which the core is covered as the optical unit.

The invention as recited in claim 8 is characterized in that in the optical device manufacturing method according to claim 7, in the smoothing film forming step, the smoothing film is formed by a material having a refractive index equal to or nearly equal to the refractive index of the core.

The invention as recited in claim 9 is characterized in that in the optical device manufacturing method according to claim 7 or 8, in the optical unit forming step, the core is formed as a plurality of layers.

The invention as recited in claim 10 is characterized in that in the optical device manufacturing method according to any one of claims 6 to 9, in the smoothing film forming process, the smoothing surface is formed by any one of dropping a liquid material of the smoothing film onto the processed surface, coating and spray.

### Effects of the Invention

According to the invention as recited in claims 1 and 6, since a smoothing film is provided on a processed surface of the optical unit, scattering loss in reflection or transmission at an end face of the optical unit can be reduced, and the processed surface as this end face and the smoothing film can be produced easily at low cost.

According to the invention as recited in claims 2 and 7, scattering loss in reflection or transmission at an end face of an optical waveguide in a core layer and a cladding layer can be reduced, and the processed surface as this end face and the smoothing film can be produced easily at low cost.

According to the invention as recited in claims 3 and 8, since the smoothing film has a refractive index equal to or nearly equal to that of the core, scattering loss at the end face can further be reduced.

According to the invention as recited in claims 4 and 9, since the core includes a plurality of layers, light transmission in a plurality of optical waveguide can be achieved.

According to the invention as recited in claim 5, since at least one of light an emitting unit, a light receiving unit and a light transmitting unit is provided, light transmission with reduced scattering loss at the end face of the optical unit can be achieved easily.

According to the invention as recited in claim 10, the smoothing film can be formed easily with high precision by any one of the following:
dropping a liquid material of the smoothing film onto the processed surface, coating and spray.

### BRIEF DESCRIPTION OF THE DRAWINGS

FIG. 1 is an external view of an optical cable 1 according to an embodiment of the present invention;
FIG. 2 is a perspective view of a connecting portion of an optical waveguide cable 2 and a transmission/reception subassembly 3a in a connector 3;
FIG. 3 is a cross sectional view, taken along line III-III, of the transmission/reception subassembly 3a shown in FIG. 2;
FIG. 4A is a cross sectional view of the optical waveguide cable 2 in a light transmitting section;
Fig. 4B is a cross sectional view of the optical waveguide cable 2 in a light receiving section;
FIG. 5A shows the optical waveguide cable in which a mirror surface portion 24 has not been formed;
FIG. 5B shows the optical waveguide cable in which a diced facet 241 has been formed;
FIG. 5C shows the optical waveguide cable in which the mirror surface portion 24 has been formed;
FIG. 6A is an SEM image of a mirror surface portion in which only a diced facet is provided;
FIG. 6B is an SEM image of the mirror surface portion 24 in which a smoothing film 242 is provided;
FIG. 7 is a graph showing the roughness of the mirror surface portion in which only the diced facet is provided and the mirror surface portion 24 in which the smoothing film 242 is provided;
FIG. 8 is a graph showing the quantity of light incident on a PD 312 in the case of an optical waveguide cable having the mirror surface portion in which only the diced facet is provided and in the case of an optical waveguide cable 2 having the mirror surface portion 24 in which the smoothing film 242 is provided;
Fig. 9 is a cross sectional view of an optical waveguide cable 2 using an optical fiber 7;
FIG. 10 is a cross sectional view of an optical waveguide cable 8;
Fig. 11 is a cross sectional view of a reflector 9 and an optical waveguide cable 2A; and
FIG. 12 is a cross sectional view of an optical waveguide cable 2B of a conventional optical cable.

### THE BEST MODE FOR CARRYING OUT THE INVENTION

In the following, embodiments of the present invention will be described in detail with reference to the attached drawings. However the present invention is not limited to the illustrated embodiments.

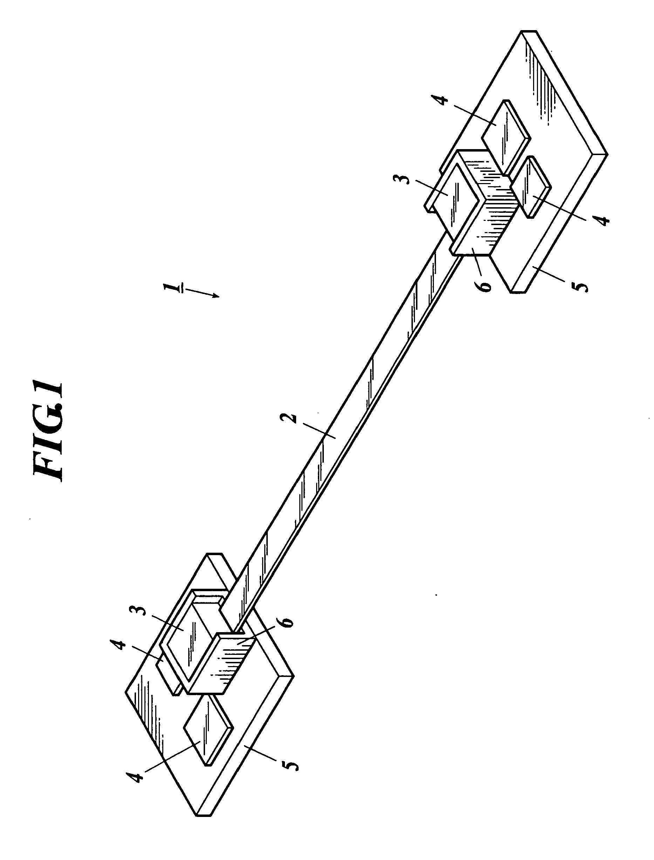

First, the configuration of an optical cable 1 according to this embodiment will be described with reference to Figs. 1 to 4B. Fig. 1 shows the configuration of optical cable 1 according to the embodiment. As shown in Fig. 1, the optical cable 1 connects two printed wiring boards 5 and is composed of an optical waveguide cable 2 serving as an optical waveguide device and connectors 3 provided at both ends thereof. The connector 3 is fitted in a socket 6 mounted on the printed wiring board 5. In addition, on the printed wiring board 5 is also mounted an IC (Integrated Circuit) 4.

The optical waveguide cable 2 is formed in a film like shape, and the optical waveguide provided in it functions as a transmission path of light that is transmitted and received between the connectors 3 provided at its both ends. The connector 3 is equipped with transmission/reception subassembly 3a that performs photoelectric conversion. The transmission/reception subassembly 3 converts an electrical signal input from the printed wiring board 5 into light and transmits light to the connector 3 that is located at the other end through the optical waveguide cable 2. The transmission/reception subassembly 3 also receives light transmitted through the optical waveguide cable from the connector 3 that is located at the other end, converts it into an electrical signal and output it to the printed wiring board 5.

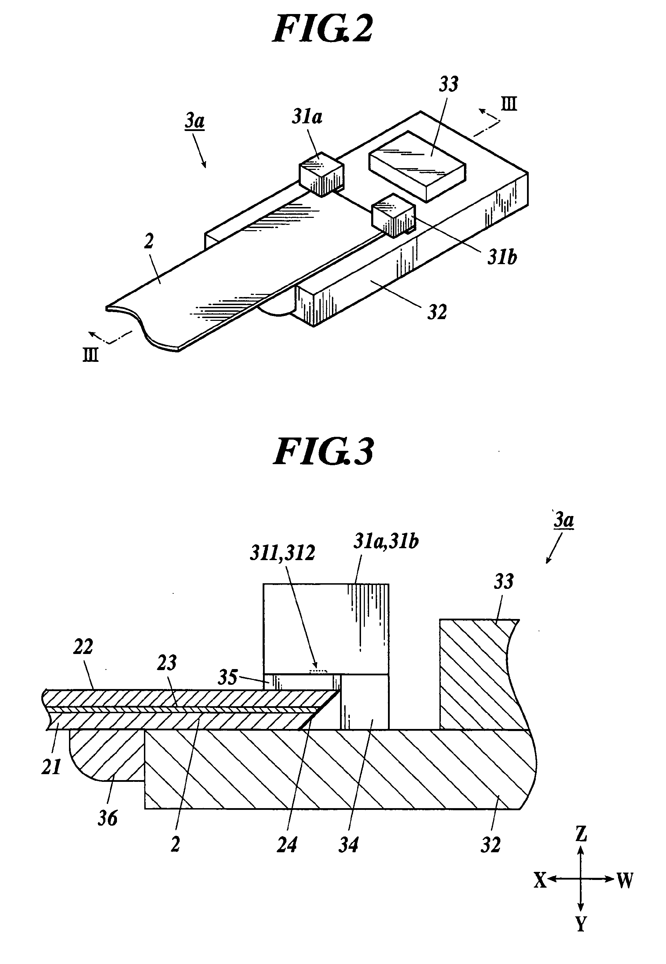

Fig. 2 is a perspective view showing the configuration of the connection portion of the optical waveguide cable 2 and the transmission/reception subassembly 3a in the connector 3. Fig. 3 is a cross sectional view taken along line III-III, showing the configuration of the transmission/reception subassembly 3a shown in Fig. 2.

As shown in Figs. 2 and 3, the end portion of the optical waveguide cable 2 is disposed between the mounting surface of a sub board 32 and a light emitting element 31a serving as a light emitting unit or a light receiving element 31b serving as a light receiving unit. The optical waveguide cable 2 is attached on and along the mounting surface in such a way that its film surface on the cladding layer 21 side is in contact with the sub board 32.

As shown in Fig. 3, the optical waveguide cable 2 is composed of cladding layers (or cladding) 21, 22 and a core layer (or core) 23 and has a mirror surface portion 24 at its end. The outer circumference of the optical waveguide cable 2 is covered with a resin film that is not shown in the drawings. The resin film, which serves as a device cover, is made of a flexible material such as a polyimide or PET (poly Ethylene Terephthalate).

The cladding layers 21, 22 and the core layer 23 are made of a resin or the like such as a polyimide resin, polysilane resin, epoxy resin or acrylate resin.

The core layer 23 is formed straightly between the cladding layers 21, 22 and constitutes an optical waveguide. The material of the core layer 23 is arranged in such a way that it has a refractive index different from that of the cladding layers 21, 22. In this way, the core layer 23 is circumferentially surrounded by the cladding layers 21, 22 that have a different refractive index, so that light emitted into the core layer 23 can be propagated in one direction without loss. As will be described later, in the core layer 23, the core layer functioning as a transmission path for light emitted from the light emitting element 31a will be denoted as core layer 231 and the core layer functioning as a transmission path for light to be received by the light receiving element 31b will be denoted as core layer 232.

The mirror surface portion 24 constitutes an optical path converting unit that reflects the light transmitted through the core layer 23 to introduce it to the light receiving element 31b located above the optical waveguide cable 2 or reflects the light emitted from the light emitting element 31a to introduce it into the core layer 23. The optical waveguide of the optical waveguide cable 2 refers to the light transmission path including the core layer 23 and the path of light in the cladding layer 22 introduced by the mirror surface portion 24. As will be described later, the mirror surface portion 24 is formed by cutting the end face of the optical waveguide cable 2 at an inclination angle of, for example, 45 degrees using a blade and forming a smoothing film 242.

The transmission/reception subassembly 3a is an assembly in which the light emitting element 31a, the light receiving element 31b and an IC 33 are mounted on the sub board 32 as shown in Fig. 2. The transmission/reception subassembly 3a performs mutual conversion between an electrical signal input/output to/from the printed wiring board 5 and light input/output through the optical waveguide cable 2.

The light emitting element 31a is provided with a VCSEL 311 serving as a photoelectric conversion element that converts an electrical signal into a light signal. The light emitting element 31a emits light corresponding to an electrical signal input from the printed wiring board 5 in the Z-to-Y direction as shown in Fig. 3. The optical path of the light emitted from the light emitting element 31a is converted by the mirror surface portion 24 and transmitted in the W-to-X direction. The photoelectric conversion element provided in the light emitting element 31a is not limited to the VCSEL, but it may be another type of photoelectric conversion element that converts an electrical signal into a light signal.

The light receiving element 31b is provided with a PD 312 serving as a photoelectric conversion element that converts a light signal into an electrical signal. The light receiving element 31b receives the light that has been transmitted through the core layer 23 of the optical waveguide cable 2 in the X-to-W direction and undergone optical path conversion into the Y-to-Z direction, and generates an electrical signal corresponding to the received light quantity. The photoelectric conversion element provided in the light receiving element 31b is not limited to the PD, but it may be another type of photoelectric conversion element that converts an electrical signal into a light signal.

Although in this embodiment, a case in which one transmission/reception subassembly 3a is provided with one light emitting element 31a and one light receiving element 31b to perform two-way light transmission is described, a configuration in which a plurality of light emitting elements 31a and a plurality of light receiving elements 31b may be provided to perform two-way light transmission in a plurality of channels may be adopted, or alternatively a configuration in which a transmission/reception subassembly 3a at one end of the optical cable 1 is provided with only a light emitting element 31a and a transmission/reception subassembly 3a at the other end is provided with only a light receiving element 31b to perform one-way light transmission may be adopted.

The height position of the photoelectric conversion element 31 is determined in accordance with the height of the optical waveguide cable 2 from the mounting surface. Specifically, the photoelectric conversion element 31 is disposed in such a way as to be spaced from the mounting surface of the sub board 32 with a bump 34 between, and the height of the photoelectric conversion element 31 has been adjusted in such a way as to be higher than the height corresponding to the thickness of the optical waveguide cable 2. The positions of the light emitting element 31a and the light receiving element 31b on the mounting surface of the board is determined in such a way that the optical axis of the light transmitted between the optical waveguide of the optical waveguide cable 2 and the VCSEL 311 of the light emitting element 31a and the optical axis of the light transmitted between the optical waveguide of the optical waveguide cable 2 and the PD 312 of the light receiving element 31b coincide with each other with reference to the mount position of the optical waveguide cable 2 on the mounting surface of the sub board 32.

The height position of the photoelectric conversion element 31 can be adjusted by changing the size of the bump 34. This means that it is possible to control the optical path distance between the optical waveguide cable 2 and the light emitting element 31a/light receiving element 31b by adjusting the bump 34. Thus, the distance can be determined in such a way that the optical coupling efficiency between the optical waveguide cable 2 and the light emitting element 31a/light receiving element 31b is maximized.

The bump 34 is made of an electrically conductive material and provides electrical connection between an electrode of the photoelectric conversion element 31 and an electrode provided on the sub board 32 (these electrodes being not shown in the drawings). The bump 34 may be made of a metal such as Au, for example.

The gap between the optical waveguide cable 2 and the light emitting element 31a/light receiving element 31b is filled with an optical path forming material 35. The optical path forming material 35 is a light refractive medium such as, for example, a light curing resin. The material for the optical path forming material 35 is selected to have a relatively large refractive index as compared to the air, namely it has a refractive index, for example, nearly equal to the cladding layer 22 of the optical waveguide cable 2. Providing the optical path forming material 35 enables control for suppressing an increase in the exit diameter of the light traveling along the optical path between the optical waveguide cable and the light emitting element 31a/light receiving element 31b. A reinforcing material 36 that supports the optical waveguide cable is provided at the disjunction portion between the sub board 32 and the optical waveguide cable 2.

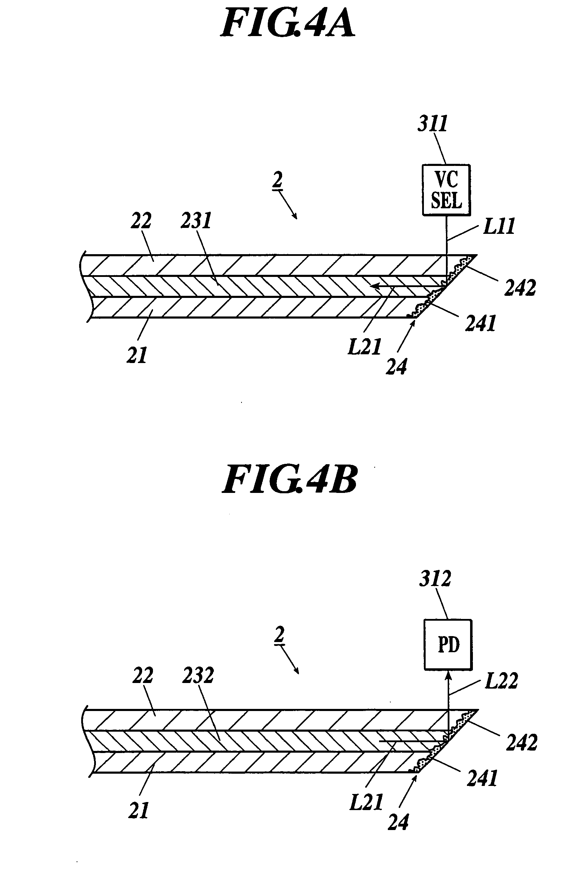

Next, the configuration of an end face of the optical waveguide cable 2 will be described with reference to Figs. 4A and 4B. Fig. 4A is a cross sectional view showing the configuration of the light transmitting section of the optical waveguide cable 2. Fig. 4B is a cross sectional view showing the configuration of the light receiving section of the optical waveguide cable 2.

As shown in Fig. 4A, in the light transmitting section of the optical waveguide cable 2, a mirror surface portion 24 is formed on the end face of the cladding layers 21, 22 and the core layer 231 serving as an optical unit. The mirror surface portion 24 is oriented at an angle of 45 degrees relative to the optical path. The mirror surface portion 24 includes a diced facet 241 and a smoothing film 242 formed on the diced facet 241.

The diced facet 241 in the form of a processed surface is a facet that has been formed by dicing, and its surface is a rough surface with unevenness. The smoothing film 242 is a film to smooth the rough surface of the diced facet 241. The material of the smoothing film 242 is, for example, a refractive index adjusting material, a polyimide resin (e.g. polyimide fluoride), a polysilane resin or an epoxy resin (e.g. ultraviolet curing resin). The material of the smoothing film 242 is a viscous liquid material, as will be described later.

From the optical point of view, it is desired that the smoothing film 242 have a refractive index nearly equal to that of the core layer 23 (231, 232). This is desirable in order to make the difference in the refractive index between the diced facet 241 and the smoothing film little to thereby reduce scattering on the diced facet 241. For example, in a case in which the refractive index of the core layer 23 is 1.519 and the refractive index of the cladding layers 21, 22 is 1.495, the refractive index of the smoothing film 242 is designed to be equal to the refractive index of the core layer or approximately 1.51.

As indicated by the arrow in Fig. 4A, laser light L11 emitted from the VCSEL 311 is reflected by the smoothing film 242 of the mirror surface portion at a right angle, and thereafter introduced as reflected light L12 into the core layer 231 and transmitted therein.

As shown in Fig. 4B, in the light receiving section of the optical waveguide cable 2, a mirror surface portion 24 is formed on the end face of the cladding layers 21, 22 and the core layer 232 in the same manner as in the light transmitting section of the optical waveguide cable 2. As indicated by the arrow in Fig. 4B, the laser light L21 having been propagated in the core layer 232 is reflected by the smoothing film 242 of the mirror surface, and thereafter introduced as reflected light L22 to the PD 312 and received by it.

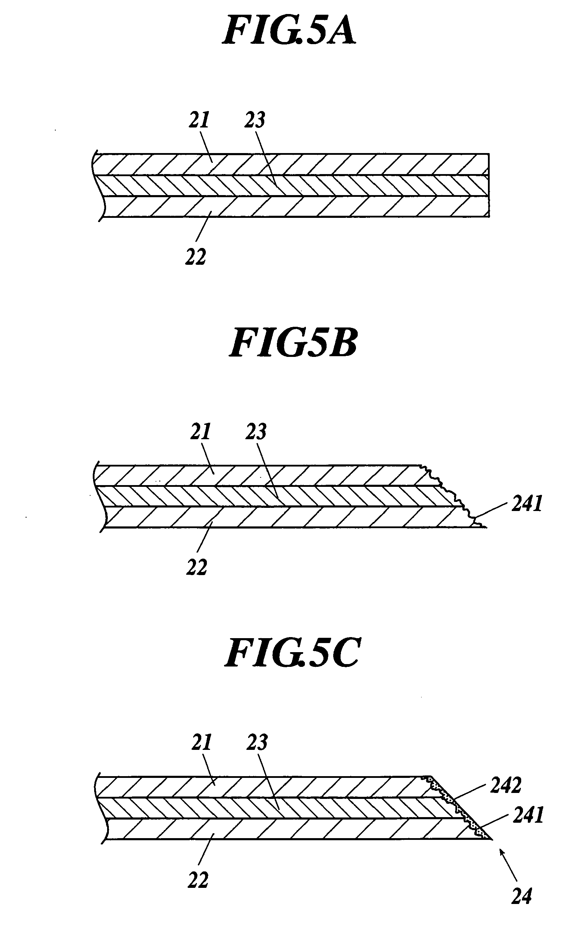

Next, a method of manufacturing the optical waveguide cable 2 will be described with reference to Figs. 5A to 5C. Fig. 5A shows an optical waveguide cable in which a mirror surface portion 24 has not been formed yet. Fig. 5B shows the optical waveguide cable in which a diced facet 241 has been formed. Fig. 5C shows the optical waveguide cable on which the mirror surface portion 24 has been formed.

First, as shown in Fig. 5A, an optical waveguide cable having cladding layers 21, 22 and a core layer 23 (231, 232) is manufactured. For example, the cladding layer 22 is formed on a substrate such as a silicon substrate by spin coating and heat treatment etc. A core film is formed on the whole area of the cladding layer 22 by spin coating and baking etc, and the core layer 23 is formed in a waveguide pattern by photolithography. Then, the cladding layer 21 is formed on the cladding layer 22 and the core layer 23 by spin coating and baking etc. Lastly, the cladding layers 21, 22 and the core layer 23 are separated as the optical waveguide cable from the substrate. The optical waveguide cable is manufactured in the form of a flexible film.

As shown in Fig. 5B, the optical waveguide cable thus formed is cut by dicing using a blade arranged at an angle of 45 degrees, so that a diced facet 241 is formed as the end face thereof. The diced facet 241 has a rough surface inclined at an angle of 45 degrees relative to the optical path (or the core layer 23).

As shown in Fig. 5C, for the optical waveguide cable on which the diced facet 241 has been formed, a liquid material for forming the smoothing film 242 is dropped on the diced facet 241. For example, the position of the diced facet 241 is adjusted in such a way that it is oriented to be perpendicular or oblique with respect to the direction of dropping of the material for forming the smoothing film 242, and then the material for forming the smoothing film 242 is dropped. Thus, the diced facet 241 is covered with the liquid material. For example, in a case in which the liquid material for forming the smoothing film 242 is an ultraviolet curing resin, the liquid material with which the diced facet 241 is covered is irradiated with ultraviolet light so as to be cured, and additionally heat-treated so as to be stabilized. Thus, the smoothing film 242 is formed, and the optical waveguide cable 2 is produced.

The optical waveguide cable 2 thus manufactured is attached to the transmission/reception subassembly 3a of the connector 3, whereby the optical cable 1 is produced.

The material for forming the smoothing film 242 is a liquid material having viscosity and adhesiveness, preferably a material having a low viscosity. If a material having a viscosity as high as, for example, 770 cP is used, the material (and the smoothing film 242) will become convex on the diced facet 241, which deteriorates the function of the mirror surface.

The process of forming the smoothing film 242 may be performed before or after the optical waveguide cable is mounted on the optical cable 1, but it is desirable that this process be performed during the mounting in order to mount the optical waveguide cable at the optimum position. The process of forming the smoothing film 242 is not limited to that performed by dropping the material, but it may be formed in other ways, such as coating (e.g. spin coating) spray etc.

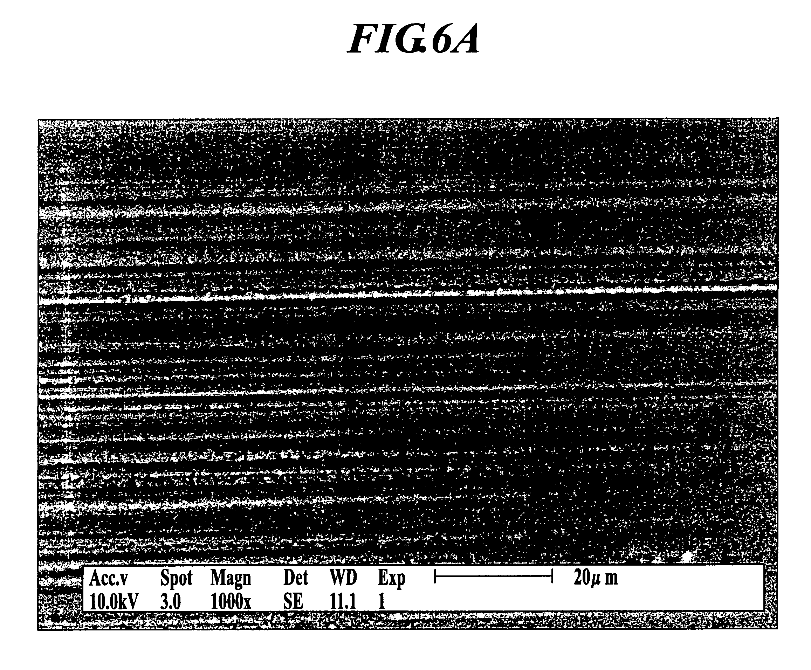

Next, a description will be made, with reference to Figs. 6A to 8, of comparisons of an optical waveguide cable 2 on which a mirror surface portion 24 provided with a smoothing film 242 has been formed and an optical waveguide cable 2 on which a mirror surface portion provided with only a diced facet 241 (without the smoothing surface 242) has been formed.

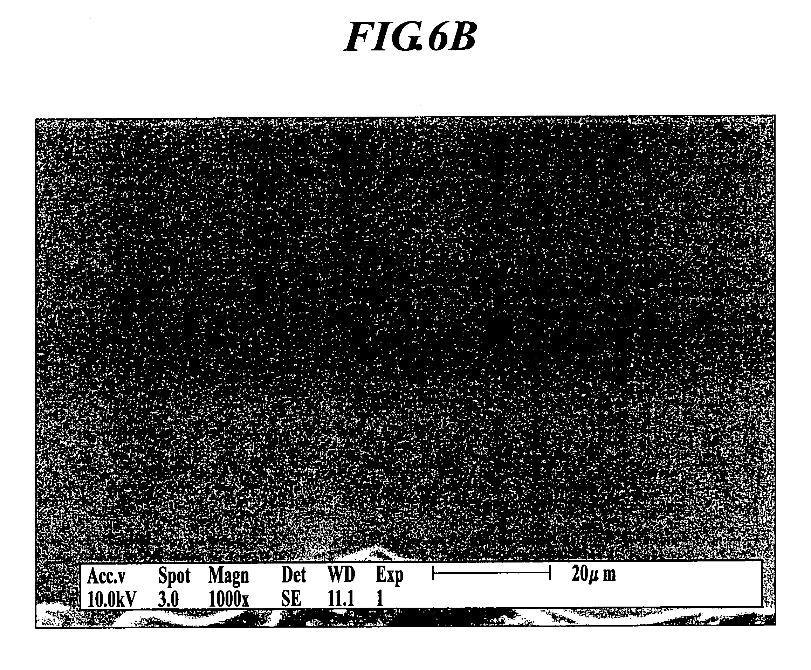

First, the result of a comparison of SEM (Scanning Electron Microscope) images of the surfaces of the mirror surface portions will be discussed with reference to Figs. 6A and 6B. Fig. 6A shows an SEM image of the mirror surface portion provided with only the diced facet. Fig. 6B shows an SEM image of the mirror surface portion 24 provided with the smoothing film 242.

As shown in Fig. 6A, in the case of the optical waveguide cable 2 in which the mirror surface portion is provided with only the diced facet, the SEM image of the surface shows streak-like unevenness caused by dicing. In the case of the optical waveguide cable 2 in which the mirror surface portion 24 is provided with the smoothing film 242, the surface is smoothed and the SEM image of the surface does not show streak-like unevenness. In this connection, it should be noted that in the SEM image shown in Fig. 6B, a dust portion formed on the smoothing film 242 is intentionally shown in the bottom portion of the SEM image to demonstrate that the image is in focus. In the dust portion of the smoothing film 242, streak-like unevenness can be seen. It will be appreciated from this that the central and upper portion of the SEM image is in focus.

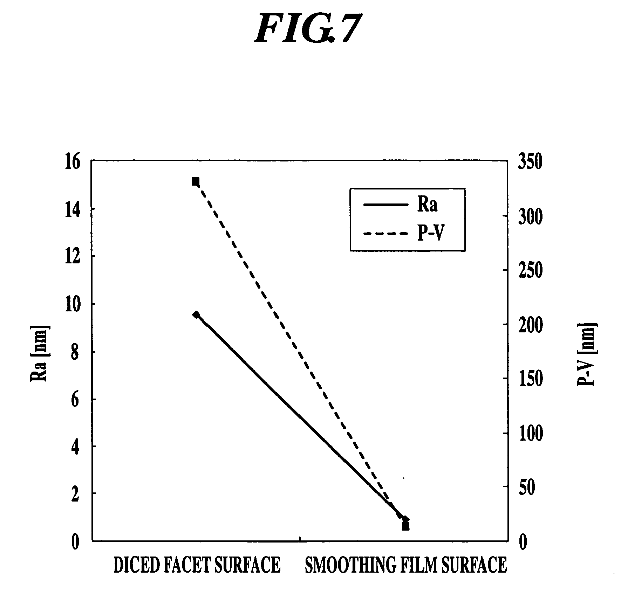

Next, a description will be made, with reference to Fig. 7, of the result of a comparison of values representing the surface roughness based on AFM (Atomic Force Microscope) measurement of the mirror surfaces. Fig. 7 shows the roughness of the mirror surface portion 24 provided with only the diced facet and the mirror surface portion 24 provided with the smoothing film 242.

For the optical waveguide cable 2, values of Ra (that is, roughness, or average surface roughness) and P-V values (the maximum height difference) were obtained from an AFM image of the surface of the mirror surface portion provided with only the diced facet and AFM measurement of the surface of the mirror surface portion 24 provided with the smoothing film 242. In the case shown in Fig. 7, the AFM measurement area was 10 × 10 µm². It will be appreciated that the Ra value and the P-V value are greatly reduced, namely the values indicative of the degree of smoothness are greatly improved in the surface of the mirror surface portion 24 provided with the smoothing surface 242 as compared to the surface of the mirror surface portion provided with only the diced facet.

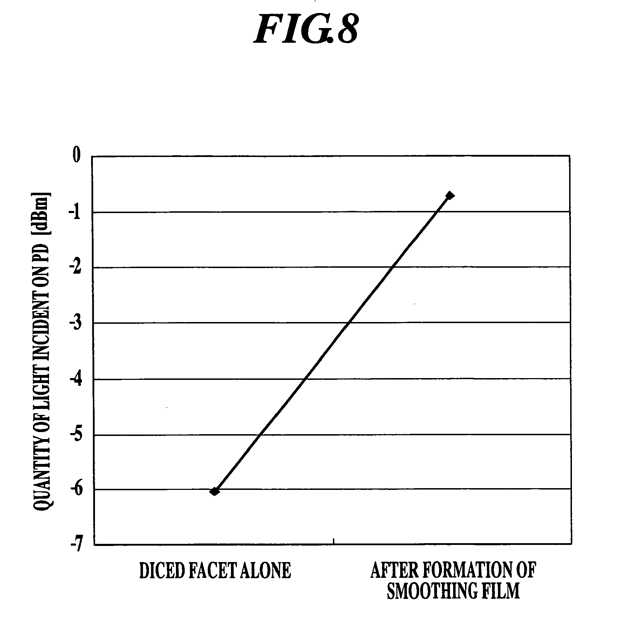

Next, a description will be made, with reference to Fig. 8, of the result of comparison of light signal loss based on measurement using an optical waveguide having a VCSEL, a PD and a mirror surface portion oriented at an angle of 45 degrees. Fig. 8 shows the quantity of light incident on the PD 312 for the optical waveguide cable having the mirror surface portion provided with only the diced facet and the optical waveguide cable 2 having the mirror surface portion 24 provided with the smoothing film 24.

As shown in Fig. 8, in the optical waveguide cable having the mirror surface portion provided with only the diced facet and the optical waveguide cable 2 having the mirror surface portion 24 provided with the smoothing film 242, laser light was emitted from the VCSEL 311 at an intensity of +2.7 dBm and caused to be reflected by the mirror surface portion, and the reflected light having been transmitted through the core layer 23 was measured by the PD. Here, a smaller quantity of light incident on the PD indicates a larger loss of the light quantity. The quantity of light incident on the PD in the optical waveguide cable 2 having the mirror surface portion 24 provided with the smoothing film 242 was larger than that in the optical waveguide cable having the mirror surface portion provided with only the diced facet, and the loss of light quantity through reflection in the mirror surface portion was reduced by 5.3 dB.

As per the above, according to this embodiment, since the optical waveguide cable 2 has the smoothing film 242 on the diced facet 241 of the core layer 23 and the cladding layers 21, 22, scattering loss in the mirror surface portion 24 can be reduced, and the mirror surface portion 24 can be produced easily at a low cost.

Furthermore, since the smoothing film 242 has a refractive index nearly equal to that of the core layer 23, scattering loss in the mirror surface portion 24 can further be reduced.

Still further, since the optical cable 1 is equipped with the VCSEL 311 and the PD 312, light transmission with a reduced scattering loss in the mirror surface portion 24 can be easily realized.

Still further, the smoothing film 242 can be produced easily with high precision by any one of the following methods: dropping a material for forming the smoothing film 242 on the diced facet, coating and spray.

The above description of the embodiment have described an example of the optical apparatus and the method of manufacturing an optical apparatus according to the present invention, and the present invention is not limited to this.

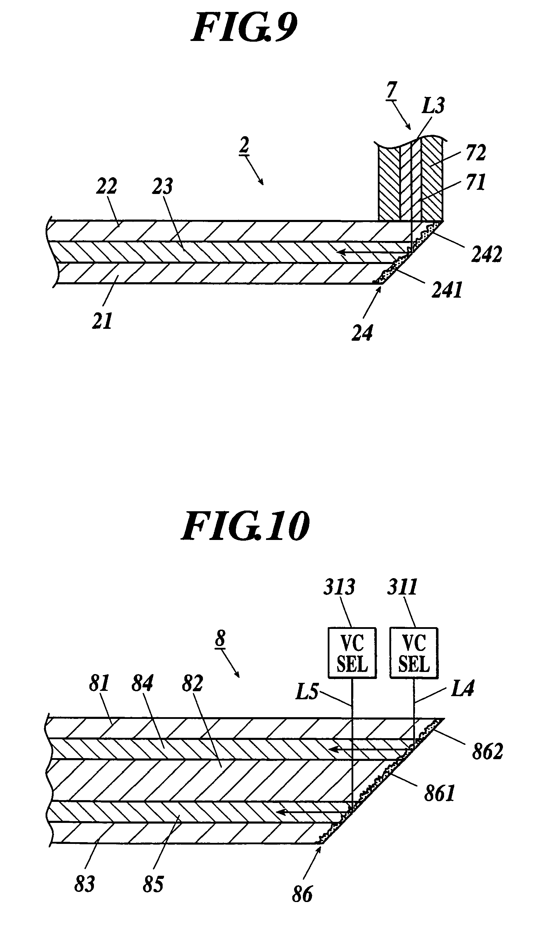

For example, although the above described embodiment uses the VCSEL 311 as a component that supplies laser light to the optical waveguide cable 2 and the PD 312 as a component that receives laser light from the optical waveguide cable 2, the invention is not limited to this. For example, as shown in Fig. 9, an optical fiber 7 may be used as a light transmission unit. Fig. 9 is a cross sectional view showing the configuration of an optical waveguide cable 2 using an optical fiber 7.

As shown in Fig. 9, the optical fiber 7 has a core 71 in the form of a center core, a cladding 72 formed in an annular shape to cover the core 71 at the center and a not-shown jacket layer with which the cladding 72 is covered. In an end portion thereof, the jacket layer is removed when to be used. Laser light L3 emitted from a not-shown light source provided upstream of the optical fiber 7 is made incident on the optical waveguide cable 2 through the core 71 of the optical fiber 7, reflected by a smoothing film 242 in the mirror surface portion 24 and transmitted in the core layer 23. Though not shown, in the light receiving section, laser light emitted from the not-shown light source upstream of the optical waveguide cable 2 is transmitted through the core layer 23, reflected by the smoothing film 242 in the mirror surface portion 24 and made incident on the core 71 of the optical fiber 7 so as to be transmitted.

Although in the above described embodiment one core layer is provided in the optical waveguide cable 2, the present invention is not limited to this. For example, two core layers may be provided in the optical waveguide cable, as shown in Fig. 10. Fig. 10 is a cross sectional view showing the configuration of an optical waveguide cable 8.

The optical waveguide cable 8 has cladding layers 81, 82, 83, a core layer 84 provided between the cladding layers 81 and 82 and a core layer 85 provided between the cladding layers 82 and 83, and a mirror surface portion 86 oriented at an angle of 45 degrees relative to the optical path is provided. The mirror surface portion 86 includes a diced facet 861 and a smoothing film 862 formed on the diced facet 861.

In the structure for transmitting light, laser light L4 emitted from a VCSEL 311 is reflected by the smoothing film 862 in the mirror surface portion 86, and the reflected light is transmitted in the core layer 84. Laser light L5 emitted from a VCSEL 313 is reflected by the smoothing film 862 in the reflection surface portion 86, and the reflected light is introduced into and transmitted in the core layer 85.

Similarly, in a structure for receiving light, light signals having been separately transmitted through two core layers 84, 85 of the optical waveguide cable 8 are reflected by the smoothing film 862 in the mirror surface portion 86, introduced to two not-shown PDs and received by them separately.

Since the two core layers are provided as above, light transmission can be performed in two optical waveguides. Furthermore, three or more core layers may be provided in an optical waveguide cable.

Although in the above described embodiment the mirror surface portion 24 having a diced facet 241 and the smoothing film 242 is provided in the optical waveguide cable 2, the present invention is not limited to this. For example, a mirror surface portion having a diced facet and a smoothing film may be applied to an optical fiber or an optical waveguide device such as an optical waveguide circuit provided on a substrate. Although in the above described embodiment the optical waveguide cable 2 provided with the mirror surface portion 24 having the diced facet 241 and the smoothing film 242 is used in the optical cable 1 serving as an optical transceiver, the present invention is not limited to this. The present invention can be applied to all the optical devices that utilize reflection by a core layer and the air.

Although in the above described embodiment the mirror surface portion 24 is oriented at an angle of 45 degrees relative to the optical path, the present invention is not limited to this. For example, the mirror surface may be oriented at an angle other than 45 degrees (e.g. 0, 10, 30 or 90 degrees).

Fig. 11 is a cross sectional view showing the configuration of a reflector 9 and an optical waveguide cable 2A. As shown in Fig. 11, a structure provided with a reflector 9 and an optical waveguide cable 2A may be adopted. As an optical unit, the reflector 9 includes a reflector body 91 and a mirror surface portion 92. The reflector body 91 is made of a material such as quartz or a polymer. As the material of the reflector body 91, a material having an appropriate refractive index that reflects light that is incident on it from the air is selected. The mirror surface portion 92 includes a diced facet 921 oriented at an angle of 45 degrees relative to the optical path and a smoothing surface 922 formed on the diced facet 921.

The optical waveguide cable 2B has cladding layers 21, 22 and a core layer 23, and an end surface portion 24A is provided at the end face of the cladding layers 21, 22 and the core layer 231. The end surface portion 24A includes a diced facet 241A oriented at an angle of 90 degrees relative to the optical path and a smoothing film 242A formed on the diced facet 241.

In the structure for transmitting light, laser light L61 emitted from a VCSEL 314 is reflected by the surface of the smoothing film 922 in the reflector 9 to generate reflected light L62. The reflected light L62 is made incident on the core layer 23 through the end surface portion 24A of the optical waveguide cable 2A and transmitted in the core layer 23. Thus, a reduction in scattering loss at the diced facets 921, 241A is achieved.

In a structure for receiving light, though not shown, light having been transmitted through the core layer of the optical waveguide cable 2A is emitted through the end surface portion 24A. The emitted light is reflected at the surface of the smoothing film 922 of the reflector 9 and received by a PD. Thus, a reduction in scattering loss at the diced facets 921, 241A is achieved.

Although in the above described embodiment a case in which the optical waveguide cable 2 is provided with the mirror surface portion 24 has been described, the present invention is not limited to this. For example, the optical waveguide cable 2 may be provided with a mirror surface portion further including a metal film (e.g. gold, silver or aluminum) formed by vapor deposition on the smoothing film 242 formed on the diced facet 241. In this configuration, scattering loss can further be reduced as compared to the configuration in which the mirror surface portion 24 includes the diced facet 241 and the smoothing film 242.

Although in the above described embodiment the description has been made of a case in which the cladding layers 21, 22 and the core layer 23 of the optical waveguide cable 2 are used as an optical unit provided with a diced facet and a smoothing film therefor, the present invention is not limited to this. For example, an optical fiber or a planar lightwave circuit may be used as the optical unit provided with a diced facet and a smoothing film therefor.

Although in the above described embodiment the optical waveguide cable 2 having a processed surface in the form of a diced facet 241 has been described, the present invention is not limited to this. For example, the processed surface may be a surface formed by cutting using a laser or a microtome.

Other appropriate modifications can be made also to detailed structures and specific operations of the optical cable 1 according to the above described embodiment without departing from the essence of the present invention.

### INDUSTRIAL APPLICABILITY

As per the above, the optical device and the optical device manufacturing method according to the present invention are suitable for devices used in optical communication and the method for manufacturing such devices.

## Claims

1. An optical device comprising:
an optical unit,
wherein said optical unit includes a processed surface for reflecting or transmitting light, and a smoothing film is provided on the processed surface.

2. An optical device according to claim 1, wherein said optical unit includes a core serving as an optical waveguide and cladding with which the core is covered.

3. An optical device according to claim 2, wherein the smoothing film has a refractive index equal to or substantially equal to a refractive index of the core.

4. An optical device according to claim 2 or 3, wherein the core has a plurality of layers.

5. An optical device according to any one of claims 1 to 4, wherein at least one of a light emitting unit for emitting light to the smoothing film, a light receiving unit for receiving light reflected by the smoothing film and a light transmitting unit for emitting light to or receiving light from the smoothing film.

6. An optical device manufacturing method comprising:
an optical unit forming step of forming an optical unit;
a processed surface forming step of forming a processed surface for reflecting or transmitting light;
a smoothing film forming step of forming a smoothing film on the processed surface to produce an optical device.

7. An optical device manufacturing method according to claim 6, wherein said optical unit forming step comprises a step of forming a core serving as an optical waveguide and cladding with which the core is covered, as said optical unit.

8. An optical device manufacturing method according to claim 7, wherein in said smoothing film forming step, the smoothing film is formed by a material having a refractive index equal to or substantially equal to a refractive index of the core.

9. An optical device manufacturing method according to claim 7 or 8, wherein in said optical unit forming step, the core is formed as a plurality of layers.

10. An optical device manufacturing method according to any one of claims 6 to 9, wherein in said smoothing film forming process, said smoothing surface is formed by any one of dropping a liquid material of the smoothing film onto the processed surface, coating and spray.
